# EUROPÄISCHE PATENTSCHRIFT

(11) **EP 2 118 977 B1**
(45) Veröffentlichungstag und Bekanntmachung des Hinweises auf die Patenterteilung: **20.06.2012**
(21) Anmeldenummer: 08707534.7
(22) Anmeldetag: 04.02.2008
(51) Int. Cl.: H01R 4/48, H01L 31/048

(54) **ANSCHLUSS- UND VERBINDUNGSDOSE FÜR EIN SOLARMODUL**
JUNCTION BOX AND CONNECTING BOX FOR A SOLAR MODULE
BOÎTIER DE RACCORDEMENT ET DE CONNEXION POUR UN MODULE SOLAIRE

(30) Priorität: 05.02.2007 DE 102007006433; 07.08.2007 DE 102007037130; 07.09.2007 DE 102007042547; 24.10.2007 DE 102007051134
(43) Veröffentlichungstag der Anmeldung: 18.11.2009
(73) Patentinhaber: Phoenix Contact GmbH & Co. KG, 32825 Blomberg (DE)
(72) Erfinder: GIEFERS, Stefan, 32760 Detmold (DE)
(74) Vertreter: Mergel, Volker
(86) Internationale Anmeldenummer: PCT/EP2008/000859
(87) Internationale Veröffentlichungsnummer: WO 2008/095670

(56) Entgegenhaltungen:
- EP-A- 1 102 354
- EP-A- 1 672 702
- DE-U1- 20 311 184
- US-A1- 2006 049 802

## Beschreibung

### Gebiet der Erfindung

Die Erfindung betrifft eine Anschluss- und Verbindungsdose für ein photovoltaisches Solarmodul mit flexiblen Flachleiterbändern, die aus der Oberfläche des Solarmoduls herausragen und ein Verfahren zum Anschließen einer Anschluss- und Verbindungsdose an ein Solarmodul.

### Hintergrund der Erfindung

Die Produktion photovoltaischer Solarmodule hat in den letzten Jahren einen regelrechten Boom erlebt, unter anderem wegen des erhöhten Bedarfs an einer umweltschonenden Energieerzeugung. Die direkte Umwandlung von Sonnenlicht in elektrischen Strom mittels photovoltaischer Solarmodule ist vollkommen emissionsfrei und nahezu mit keinerlei Risiken für Mensch und Umwelt verbunden. Daher werden in letzter Zeit zum Beispiel bei Neubauten ganze Dächer mit Solarmodulen belegt und sogar "Solarkraftwerke" gebaut. Durch die technische Entwicklung der Photovoltaik wird der Einsatz der Solarmodule mehr und mehr auch in ungünstigeren Breitengraden, wie z. B. Mitteleuropa oder Nordamerika, immer effizienter, so dass insbesondere in diesen Regionen eine große Nachfrage besteht. Eine stetige Effizienzsteigerung der Solarmodule aufgrund technischer Weiterentwicklung einerseits sowie steigende Energieproduktionskosten mit anderen Energieträgern, wie fossilen Brennstoffen oder Kernenergie, machen die photovoltaische Stromerzeugung mehr und mehr konkurrenzfähig.

Es ist ersichtlich, dass der Erfolg von Solarmodulen im wirtschaftlichen Wettbewerb mit anderen Energieträgern von den Kosten für Herstellung und Montage der Solarmodule abhängt.

Solarmodule bestehen typischerweise aus einer Vielzahl von Solarzellen auf Halbleiterbasis, welche zu großflächigen Solarpaneelen zusammengeschaltet werden. Ein typisches Solarmodul besitzt auf der der Sonne zugewandten Seite eine Glasscheibe und an der Rückseite eine transparente Kunststoffschicht, in der die Solarzellen eingebettet sind. Die Rückseite des Solarmoduls ist typischerweise mit einer witterungsfesten Kunststoffverbundfolie, z. B. Polyvinylfluorid und Polyester, kaschiert. Die mono- oder polykristallinen Solarzellen sind durch Lötbändchen elektrisch miteinander verschaltet. Typischerweise ist das Solarmodul noch in einen Metallprofilrahmen zur Befestigung und Versteifung des Verbundes eingebaut. Ein Solarmodul ist daher grundsätzlich ein flächiges Gebilde, ähnlich einer dicken Glasscheibe.

Typischerweise besitzen Solarmodule auf der der Sonne abgewandten Rückseite dünne flexible Leiterbänder, zumeist aus Kupfer, welche aus der Rückseite des Solarmoduls senkrecht herausragen. Diese flexiblen Flachleiterbänder sind sehr empfindlich und daher schwierig zu kontaktieren. Hinzu kommt, dass aufgrund der scheibenartigen Form des Solarmoduls ein mechanischer Angriff zur Befestigung eines elektrischen Verbinders ebenfalls schwierig ist. Daher hat sich eine spezielle Art des elektrischen Verbinders für derartige Solarmodule entwickelt, welche als Anschlussdose oder Anschluss- und Verbindungsdose bezeichnet wird. Die Anschluss- und Verbindungsdose wird typischerweise auf die rückwärtige Oberfläche des Solarmoduls aufgeklebt und besitzt im Inneren elektrische Anschlusseinrichtungen zum Kontaktieren der flexiblen Flachleiterbänder des Solarmoduls. Ferner besitzt die Anschluss- und Verbindungsdose ggf. eine Einrichtung zum Anschließen eines elektrischen Anschlusskabels, welches mittels der Anschluss- und Verbindungsdose mit dem flexiblen Flachleiterband des Solarmoduls verbunden wird, um den von dem Solarmodul erzeugten elektrischen Strom abzuführen.

Ferner werden typischerweise mehrere Solarmodule in Reihenschaltung betrieben, wobei antiparallel zu jedem Modul eine sogenannte Bypass- oder Freilaufdiode geschaltet wird. Die Freilaufdiode ist innerhalb der Anschluss- und Verbindungsdose an die elektrische Anschlussvorrichtung angeschlossen. Ohne Bypass-Diode würde, wenn ein Modul verschattet ist oder durch einen Defekt keinen Strom liefert, dieses Modul die Leistung der in Reihe geschalteten Solarmodule verringern oder sogar Schaden nehmen. Durch die Bypass-Diode wird dies verhindert, da der Strom durch die Diode fließt und aufrecht erhalten wird.

Es ist ersichtlich, dass aufgrund der mechanischen Gegebenheiten, insbesondere Form des Solarmoduls und der Empfindlichkeit der flexiblen Flachleiterbänder, eine Reihe von Schwierigkeiten für die Konstruktion der Anschluss- und Verbindungsdosen auftreten.

Bisher sind Anschlussdosen bekannt, die über die flexiblen Flachleiterbänder gestülpt werden und wobei das flexible Flachleiterband in Handarbeit umgebogen und mittels einer Anschlussklemme oder einer Lötverbindung kontaktiert wird. In einem weiteren Arbeitsgang wird dann die Anschlussdose geschlossen. Derartige Verbindungsvorrichtungen bzw. Anschlussdosen sind in der DE 10 2005 025 632 A1, der DE 20 2005 018 884 U1, der DE 203 11 184 U1 und der US 2006/0049802 A1 beschrieben. Bei der in der EP 1 102 354 A1 beschriebenen Vorrichtung werden die Folienleiter des Solarmoduls noch in ein Gel-Element eingesetzt. Es ist ersichtlich, dass die Montage derartiger Verbindungsvorrichtungen bzw. Anschlussdosen umständlich ist und sich diese nur schwer für die automatisierte Massenfertigung eignen.

Aus der DE 103 58 140 B4 und der EP 1 672 702 A1 ist eine elektrische Anschluss- und Verbindungsdose für ein Solarzellenmodul bekannt, welche an ihrer Unterseite eine Führungseinrichtung aufweist, in welcher das dünne Leiterband mit geringem Spiel in Querrichtung geführt wird, um ein Knicken oder Falten der Leiterbänder beim Einführen in die Klemmeinrichtung zu vermeiden. Nachteilig hierbei ist, dass das Leiterband in die enge Führungseinrichtung eingefädelt werden muss und die Klemmkraft der Klemmeinrichtung trotzdem relativ gering sein dürfte, um das dünne Leiterband in die Klemmeinrichtung einschieben zu können.

Nach alledem besteht aufgrund des hohen Innovationsdrucks in der Herstellung von Solarmodulen diesbezüglich Verbesserungsbedarf.

### Allgemeine Beschreibung der Erfindung

Es ist daher eine Aufgabe der vorliegenden Erfindung, eine Anschluss- und Verbindungsdose für ein photovoltaisches Solarmodul bereitzustellen, welche einfach, schnell und effizient, insbesondere automatisiert, z.B. mit einem Roboter, an das Solarmodul angeschlossen werden kann.

Eine weitere Aufgabe der Erfindung ist es, eine derartige Anschluss- und Verbindungsdose bereitzustellen, welche eine hohe Kontaktsicherheit und Langlebigkeit bietet.

Eine weitere Aufgabe der Erfindung ist es, eine derartige Anschluss- und Verbindungsdose bereitzustellen, welche die Nachteile des Standes der Technik vermeidet oder zumindest mindert und kostengünstig herzustellen sowie zu montieren ist.

Die Aufgabe der Erfindung wird durch den Gegenstand der unabhängigen Ansprüche gelöst. Vorteilhafte Weiterbildungen sind Gegenstand der abhängigen Ansprüche.

Erfindungsgemäß wird eine Anschluss- und Verbindungsdose für ein photovoltaisches Solarmodul zum Kontaktieren eines oder mehrerer flexibler Flachleiterbänder, die aus der Oberfläche des Solarmoduls herausragen, bereit gestellt.

Die Anschluss- und Verbindungsdose umfasst ein dielektrisches Gehäuse zum Aufsetzen auf das Solarmodul und mit einer Einführöffnung an der Unterseite des Gehäuses. Es ist ersichtlich, dass der Begriff Unterseite nicht im Sinne einer absoluten Orientierung im Raum zu verstehen ist, sondern als Unterseite wird diejenige Seite der Anschluss- und Verbindungsdose bzw. des Gehäuses bezeichnet, die im montierten Zustand dem Solarmodul zugewandt ist, also die Seite die an dem Solarmodul zur Anlage kommt. Typischerweise wird die Anschluss- und Verbindungsdose an der sonnenabgewandten Rückseite des Solarmoduls angebracht.

An der Unterseite des Gehäuses ist eine Einführöffnung vorgesehen, in die das Flachleiterband automatisch eingeführt wird, wenn das Gehäuse mit der Einführöffnung über das Flachleiterband gestülpt wird. Die Einführöffnung ist insbesondere wesentlich größer ausgebildet als die Dimension des Flachleiterbandes, damit das Flachleiterband geradlinig und ohne von diesem geführt zu werden, frei in das Gehäuse eingeführt werden kann. Dies hat den Vorteil, dass das Flachleiterband nicht an das Gehäuse anstößt und damit die Gefahr einer Beschädigung des empfindlichen Flachleiterbands, insbesondere ein Knicken beim Einführen vermieden werden kann.

In dem Gehäuse ist eine elektrische Anschlussvorrichtung angeordnet, die eine Kontaktklemme zum elektrischen Kontaktieren des flexiblen Flachleiterbands aufweist. In dem Montagezustand, in dem das Gehäuse auf das Solarmodul aufgesetzt und über das Flachleiterband gestülpt wird, ist die Kontaktklemme geöffnet, damit das empfindliche Flachleiterband möglichst ohne anzustoßen in einen freien Raumbereich innerhalb der geöffneten Kontaktklemme eingeführt werden kann. In diesem Raumbereich wird das Flachleiterband beim Schließen der Kontaktklemme von dieser erfasst (eingefangen) und kontaktiert. Daher wird dieser Raumbereich der Kontaktklemme als Einfangraumbereich bezeichnet. Somit weist die Anschluss- und Verbindungsdose zwei unterschiedliche Zustände auf, nämlich den Montagezustand, in dem die Kontaktklemme geöffnet ist und den Kontaktzustand, in dem die Kontaktklemme geschlossen ist, das Flachleiterband festhält und elektrisch kontaktiert.

Das Schließen der Kontaktklemme, d.h. die Überführung der Anschluss- und Verbindungsdose vom Montagezustand in den Kontaktzustand, erfolgt durch aktive Betätigung der Kontaktklemme, mittels einer Betätigungseinrichtung, wenn die Anschluss- und Verbindungsdose auf das Solarmodul aufgesetzt und das flexible Flachleiterband in das Gehäuse eingeführt ist. Je nach Ausgestaltung der Anschluss- und Verbindungsdose kann die Betätigung unmittelbar beim Aufsetzvorgang in einem einzigen Arbeitsschritt oder nach dem Aufsetzen in einem zweiten Schritt erfolgen. Die Betätigungseinrichtung umfasst hierzu einen Betätigungsvorsprung innerhalb des Gehäuses, z.B. eine Betätigungsrippe oder einen Betätigungsstift, welcher die geöffnete Kontaktklemme kraftbeaufschlagt und sie dadurch schließt.

Vorteilhafterweise erlaubt das aktive Schließen der Kontaktklemme bei der vorliegenden Erfindung eine durch die Ausgestaltung der Kontaktklemme wählbare, und damit, falls erwünscht, hohe Kontaktkraft der Klemmung des Flachleiterbandes, was sich vorteilhaft aus die Kontaktsicherheit und -dauerhaftigkeit auswirken kann.

Erfindungsgemäß ist das Gehäuse zumindest zweiteilig ausgebildet und die beiden Gehäuseteile sind relativ zueinander bewegbar, z.B. relativ zueinander verschiebbar. Ferner ragt in dem Montagezustand das erste der beiden Gehäuseteile an der dem Solarmodul zugewandten Seite über das zweite der beiden Gehäuseteile hinaus. Beim Aufsetzen der Anschluss- und Verbindungsdose kommt daher zunächst nur das erste der beiden Gehäuseteile an dem Solarmodul zur Anlage. Die Anschlussvorrichtung ist an diesem ersten Gehäuseteil befestigt. Durch Drücken des zweiten Gehäuseteils in Richtung des Solarmoduls wird die Relativverschiebung zwischen den beiden Gehäuseteilen und damit auch des zweiten Gehäuseteils relativ zur Anschlussvorrichtung in Gang gesetzt, da sich das erste Gehäuseteil mit der Anschlussvorrichtung an dem Solarmodul abstützt und die Betätigungseinrichtung, welche an dem zweiten Gehäuseteil befestigt ist, schließt automatisch die Kontaktklemme. Vorteilhafterweise kann die Kontaktklemme also ausschließlich durch Angriff an das Gehäuse von außen und ohne manuellen Eingriff in das Gehäuseinnere geschlossen werden.

Zweckmäßig weist eines der beiden Gehäuseteile hierfür eine Mehrzahl von Führungshülsen und das andere Gehäuseteil hiermit korrespondierende Führungsstifte auf, die zusammen eine lineare Führung senkrecht zur Oberfläche des Solarmoduls bilden. Besonders bevorzugt sind in dem Montagezustand die Führungsstifte in die Führungshülsen noch nicht vollständig eingesteckt und in dieser Position selbsthemmend oder -klemmend festgelegt, so dass wenn das zweite Gehäuseteil z.B. von einem Montageroboter gefasst und von oben auf das Solarmodul aufgesetzt wird, das erste Gehäuseteil mit der Anschlussvorrichtung nicht ab- oder herausfällt. Beim Aufsetzen der Anschluss- und Verbindungsdose auf das Solarmodul wird durch Kraftbeaufschlagung auf das zweite Gehäuseteil in Richtung des Solarmoduls die Selbsthemmung der Verschiebeeinrichtung überwunden, um die Relativverschiebung des zweiten gegenüber dem ersten Gehäuseteil zu bewirken und mittels der Betätigungseinrichtung an dem zweiten Gehäuseteil die Kontaktklemme zu schließen. Das Schließen der Kontaktklemme erfolgt also automatisch beim Aufsetzen der Anschluss- und Verbindungsdose, bewirkt durch die Relativverschiebung.

Diese Maßnahmen ermöglichen eine besonders einfache und effiziente automatisierte Montage, vor allem, wenn der Montageroboter die Anschluss- und Verbindungsdose von einer Zuführeinrichtung aufgreift und beim Aufsetzen der Anschluss- und Verbindungsdose auf das Solarmodul lediglich eine Linearbewegung senkrecht zum Solarmodul auszuführen braucht.

Das erste Gehäuseteil ist demnach als Bodenelement zur Anlage an das Solarmodul ausgebildet, dient aber gleichzeitig als Halterung für die Anschlussvorrichtung, welche mit dem Bodenelement fest verbunden ist. Hierzu weist das Bodenelement z.B. Rastelemente auf, mittels denen die Anschlussvorrichtung an dem Bodenelement verrastet ist. Das zweite Gehäuseteil ist als Deckelteil ausgebildet. Zumindest eines der beiden Gehäuseteile, vorzugsweise das Deckelteil, weist umlaufende Seitenwände auf, so dass das erste und zweite Gehäuseteil gemeinsam, abgesehen von vordefinierten Öffnungen, z.B. an der Unterseite und an den Seitenwänden zum Einführen der Anschlusskabel eine geschlossene und spritzwasserdichte Box für die Anschlussvorrichtung definiert, wenn das Gehäuse in dem Kontaktzustand mit dem Solarmodul fest verbunden ist. Vorzugsweise ist das Deckelteil hutartig ausgebildet und weist einen umlaufenden Rand mit einer Klebstoffnut auf, um das Deckelteil im Kontaktzustand auf der Oberfläche des Solarmoduls festzukleben. In dem Kontaktzustand liegen dann sowohl das Bodenelement und das Deckelelement bündig an dem Solarmodul an. Demnach braucht das Bodenelement nicht zwangsläufig den gesamten Boden der Anschluss- und Verbindungsdose zu bedecken, es genügt vielmehr, das Bodenelement insoweit zu dimensionieren, dass es seiner Funktion zum Abstützen an dem Solarmodul und zum Befestigen der Anschlussvorrichtung Genüge leistet. Falls gewünscht, kann das Bodenelement zusätzlich zu dem Deckelelement mit dem Solarmodul verklebt sein.

Die Kontaktklemme ist vorzugsweise als eine Federkraftklemme mit einer Klemmfeder, z.B. aus Federmetall und einem Gegenklemmelement ausgebildet, wobei die Federkraftklemme im Montagezustand von sich aus geöffnet ist und durch Kraftbeaufschlagung mittels der Betätigungseinrichtung geschlossen wird. Hierzu besitzt die Klemmfeder einen Rastmechanismus der die Klemmfeder in dem geöffneten Zustand verrastet, z.B. in Form von Rastnasen, die in dem Montagezustand hinter Vorsprüngen an einem Halterahmen der Kontaktklemme überwindbar hemmend festgelegt sind. Hierdurch wird gewährleistet, dass die Kontaktklemme bei der Handhabung sicher offen gehalten wird, bis sie unter Überwindung der Offen-Verrastung aktiv mittels der Betätigungseinrichtung geschlossen wird.

Besonders bevorzugt wird eine Kontaktklemme eingesetzt, bei welcher die Klemmfeder und/oder das Gegenklemmelement schwenkbar an dem Halterahmen der Anschlussvorrichtung gelagert ist. Die Betätigung der Kontaktklemme bewirkt dann eine Schwenkbewegung zumindest eines der Klemmfeder oder des Gegenklemmelementes zum Schließen der Kontaktklemme und damit des elektrischen Kontakt mit dem flexiblen Flachleiterband. Die Kontaktierung des Flachleiterbandes erfolgt vorzugsweise unter einem Winkel zur Solarmodulnormalen (z.B. 45° oder 90°). Somit besitzt die Kontaktkraft der Kontaktklemme zwischen den beiden Kontaktelementen (Federklemme und Gegenklemmelement) eine Vektorkomponente senkrecht zur Oberfläche des Solarmoduls. Hierdurch kann je nach Ausgestaltung der Kontaktklemme ggf. der Betätigungsmechanismus vereinfacht werden und dennoch eine hohe und dauerhafte Kontaktsicherheit erzielt werden.

Im Folgenden sind zwei Ausführungsbeispiele im Detail beschrieben, nämlich eines, bei welchem beim Aufsetzen der Anschluss- und Verbindungsdose das flexible Flachleiterband direkt in den offenen Einfangraumbereich der geöffneten Kontaktklemme eingeführt wird und eines bei welchem beim Aufsetzen der Anschluss- und Verbindungsdose das flexible Flachleiterband durch die Einführöffnung zunächst in einen offenen Zwischenraumbereich in dem Gehäuse eingeführt wird und die Anschluss- und Verbindungsdose eine Umlenkeinrichtung für das flexible Flachleiterband aufweist, welche das flexible Flachleiterband von dem Zwischenraumbereich in den Einfangraumbereich der Kontaktklemme umlenkt. Vorzugsweise umfasst die Umlenkeinrichtung bei dem zweitgenannten Ausführungsbeispiel einen Umlenkhebel, welcher betätigt wird, wenn die Anschluss- und Verbindungsdose auf das Solarmodul aufgesetzt ist und das flexible Flachleiterband nach dem Einführen durch die Einführöffnung in das Gehäuse zu der Kontaktklemme hin umbiegt, so dass das flexible Flachleiterband nach dem Umbiegen in den Einfangraumbereich der Kontaktklemme ragt und dann von dieser durch Schließen der Kontaktklemme erfasst und elektrisch kontaktiert wird.

Beiden genannten Ausführungsbeispielen ist gemein, dass anders als bei dem in der Einleitung beschriebenen Stand der Technik die Kontaktklemme nicht mittels des dünnen Flachleiterbandes aufgedrückt wird, sondern das Flachleiterband zunächst im Wesentlichen widerstandsfrei vollständig durch die Einführöffnung hindurch in einen offenen Raumbereich in dem Gehäuse der Anschluss- und Verbindungsdose eingeführt wird. Insbesondere ist die Einführöffnung erheblich größer als die Querschnittsdimensionen des Flachleiterbandes. Vorteilhafterweise kann hiermit die Gefahr einer Beschädigung des empfindlichen Flachleiterbandes vermindert werden. Ferner besitzt die Anschluss- und Verbindungsdose eine gewisse Toleranz in Bezug auf die laterale Positionierung auf dem Solarmodul.

Im Folgenden wird die Erfindung anhand von Ausführungsbeispielen und unter Bezugnahme auf die Figuren näher erläutert, wobei gleiche und ähnliche Elemente der beiden Ausführungsbeispiele mit gleichen Bezugszeichen versehen sind und die Merkmale der beiden Ausführungsbeispiele miteinander kombiniert werden können.

### Kurzbeschreibung der Figuren

Es zeigen:
- Fig. 1: eine perspektivische Ansicht von oben auf den Gehäusedeckel einer ersten Ausführungsform der Anschluss- und Verbindungsdose,
- Fig. 2: eine perspektivische Ansicht von unten auf und in den Gehäusedeckel aus Fig. 1,
- Fig. 3: einen Querschnitt quer zu dem Solarmodul durch die Anschluss- und Verbindungsdose gemäß der ersten Ausführungsform mit der elektrischen Anschlussvorrichtung im geöffneten Montagezustand,
- Fig. 4: einen Querschnitt quer zu dem Solarmodul durch die Anschluss- und Verbindungsdose gemäß der ersten Ausführungsform mit der Anschlussvorrichtung im geschlossenen Kontaktzustand,
- Fig. 5: eine perspektivische Darstellung zweier Anschlussvorrichtungen mit dem Bodenelement gemäß der ersten Ausführungsform,
- Fig. 6: eine perspektivische vergrößerte Darstellung einer der Anschlussvorrichtungen aus Fig. 5,
- Fig. 7: eine perspektivische Ansicht von oben auf den Gehäusedeckel einer zweiten Ausführungsform der Anschluss- und Verbindungsdose,
- Fig. 8: eine perspektivische Ansicht von unten auf und in den Gehäusedeckel aus Fig. 7,
- Fig. 9: einen Querschnitt quer zu dem Solarmodul durch die Anschluss- und Verbindungsdose gemäß der zweiten Ausführungsform mit der elektrischen Anschlussvorrichtung im geöffneten Montagezustand,
- Fig. 10: einen Querschnitt quer zu dem Solarmodul durch die Anschluss- und Verbindungsdose aus Fig. 9 mit der Anschlussvorrichtung im Zwischenzustand,
- Fig. 11: einen Querschnitt quer zu dem Solarmodul durch die Anschluss- und Verbindungsdose aus Fig. 9 mit der Anschlussvorrichtung im geschlossenen Kontaktzustand und
- Fig. 12: eine perspektivische teilweise geschnittene Darstellung des Bodenelements mit zwei Anschlussvorrichtungen gemäß der zweiten Ausführungsform.

### Detaillierte Beschreibung der Erfindung

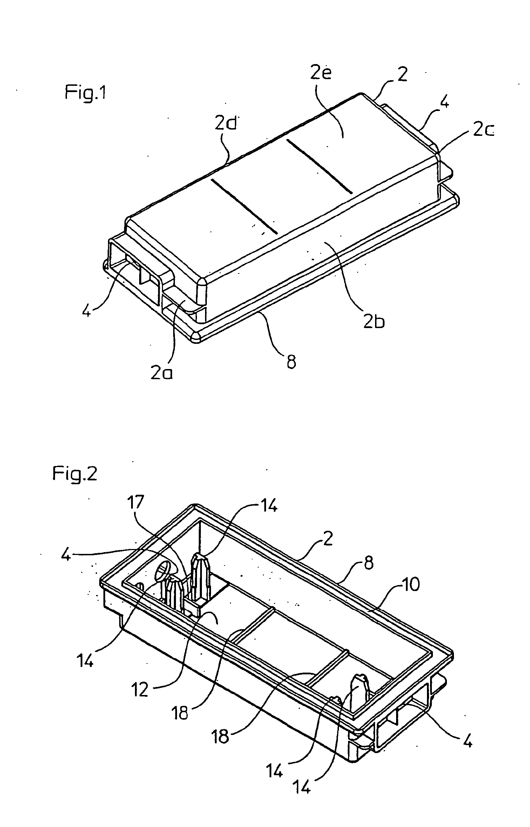

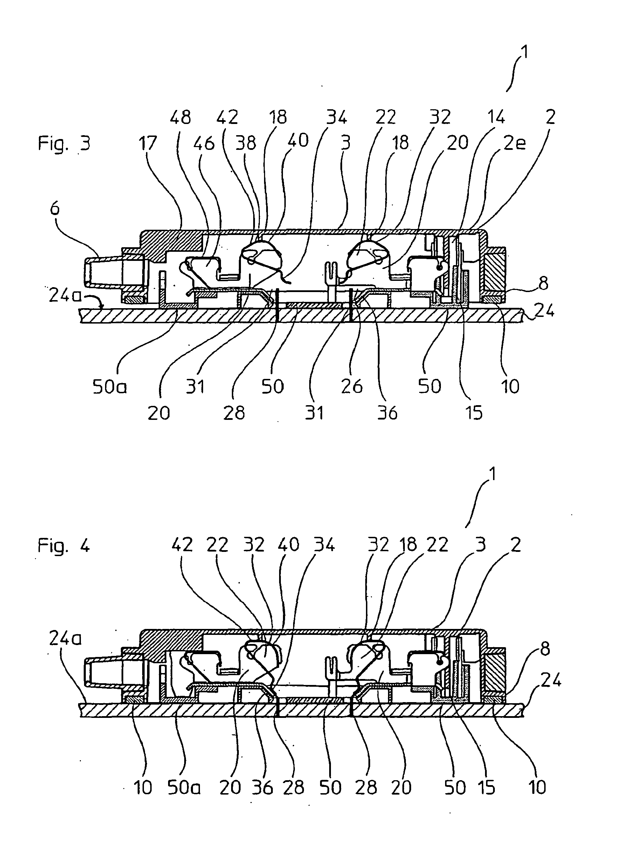

Bezug nehmend auf die Fig. 1-2 weist die Anschluss- und Verbindungsdose einen Gehäusedeckel 2 aus Kunststoff auf. Der Gehäusedeckel 2 wird gebildet von einem im Wesentlichen rechteckigen Rahmen aus vier Seitenwänden 2a bis 2d und einer die vier Seitenwände verbindenden und parallel zu dem Solarmodul verlaufenden, geschlossenen Deckelplatte 2e. Der fünfseitig geschlossene und nach unten offene Gehäusedeckel 2 ist z. B. einstückig aus Kunststoff gespritzt. In Anschlusskabeldurchführungen 4 werden jeweils separate Knickschutztüllen 6 (vgl. Fig. 3 und Fig. 4) eingesetzt.

Bezug nehmend auf Fig. 2 ist der Gehäusedeckel 2 nach unten offen und weist einen nach außen vorragenden Befestigungsrahmen 8 mit einer umlaufenden Klebstoffnut 10 auf, so dass der Gehäusedeckel 2 eine hutartige Form besitzt. Mittels des in die Klebstoffnut 10 eingebrachten Klebstoffs wird die Anschluss- und Verbindungsdose letztlich auf dem Solarmodul dauerhaft festgeklebt. Die hut- oder wannenartige Form des Gehäusedeckels bildet einen inneren Hohlraum 12, in dem die in Fig. 2 nicht dargestellten Anschlussvorrichtungen im montierten Zustand im Wesentlichen wasserdicht beherbergt werden.

Von der Unterseite der Deckelplatte 2e ragen Führungsstifte 14 in den Hohlraum 12. Auf der Innenseite der Anschlusskabeldurchführungen 4 ist zwischen zwei Führungsstiften 14 ein Klemmsteg 17 für das nicht dargestellte Anschlusskabel vorgesehen. Ferner weist die Unterseite der Deckelplatte 2e zwei Betätigungseinrichtungen 18 auf. Die Betätigungseinrichtungen 18, deren Funktion nachstehend noch genauer erläutert wird, sind in diesem Ausführungsbeispiel in Form von quer verlaufenden Betätigungsstegen ausgebildet, die einstückig mit dem Gehäusedeckel 2 ausgebildet sind.

Bezug nehmend auf Fig. 3 sind in dem von Gehäusedeckel 2 und Bodenelement 50 gebildeten Gehäuse 3 der Anschluss- und Verbindungsdose 1 zwei identische Anschlussvorrichtungen 20 angeordnet. Da die beiden Anschlussvorrichtungen 20 identisch ausgebildet sind, wird im Folgenden lediglich auf eine der beiden Anschlussvorrichtungen 20 Bezug genommen.

Fig. 3 zeigt die Anschluss- und Verbindungsdose in dem Montagezustand, in dem die Kontaktklemme 22 geöffnet ist. Das Bodenelement 50 an welchem die Anschlussvorrichtung 20 befestigt ist, weist Führungshülsen 15 auf, in die die Führungsstifte 14 eingesetzt sind. Die Führungsstifte 14 klemmen in den zugehörigen Führungshülsen 15, derart, dass beim Aufsetzen der Anschluss- und Verbindungsdose 1 auf das Solarmodul 24 das Bodenelement 50 klemmend an dem Gehäusedeckel 2 festgehalten wird, so dass das Gehäuse 3 an dem Gehäusedeckel 2 von einem Roboter gefasst und automatisiert aufgesetzt werden kann, ohne dass das Bodenelement 50 und die Anschlussvorrichtung 20 herausfallen. Andererseits ist die Klemmung zwischen den Führungsstiften 14 und den Führungshülsen 15 durch Kraftbeaufschlagung überwindlich, um eine Relativverschiebung zwischen dem Gehäusedeckel 2 und dem Bodenelement 50 mit der Anschlussvorrichtung 20 zu ermöglichen, nämlich wenn eine Mindestkraft überschritten wird. Die Führungshülse 15 ist in diesem Beispiel geschlitzt, um die überwindlich klemmende Zusammenwirkung mit dem Führungsstift 14 zu verbessern.

In dem geöffneten Montagezustand ist die Anschlussvorrichtung 20 noch nicht vollständig in den Gehäusedeckel 2 eingeschoben und das Bodenelement 50 ragt noch ein Stück weit (einige Millimeter) aus dem Gehäusedeckel 2 nach unten, d.h. an der dem Solarmodul zugewandten Seite, heraus. Es besteht in dem Montagezustand also ein Versatz zwischen der Unterseite 50a des Bodenelements 50 und dem Befestigungsrahmen 8 des Gehäusedeckels 2, so dass beim Aufsetzen der Anschluss- und Verbindungsdose 1 zunächst das Bodenelement 50 mit dem Solarmodul 24 in Anlage kommt und in diesem in Fig. 3 gezeigten Zustand der Befestigungsrahmen 8 noch von der Oberfläche 24a des Solarmoduls 24 beabstandet ist.

Das Bodenelement 50 weist eine relativ große Öffnung 26 an ihrer dem Solarmodul 24 zugewandten Unterseite 50a auf. Dies sorgt dafür, dass das empfindliche, flexible Flachleiterband 28, das sogenannte "Ribbon", in dem geöffneten Montagezustand hindernis- und widerstandsfrei von unten durch die Einführöffnung 26 in das Gehäuse 3 und die Anschlussvorrichtung 20 eingeführt werden kann. Hierdurch ist die Gefahr einer Beschädigung des Flachleiterbandes 28 reduziert. Die Kontaktklemme 22 definiert in diesem Zustand einen offenen Einfangraumbereich 31, in den das Flachleiterband 28 beim Aufsetzen der Anschluss- und Verbindungsdose von unten her widerstandsfrei eintaucht. Vorzugsweise findet in diesem Zustand noch keine Berührung zwischen der Kontaktklemme 22 und dem Flachleiterband 28 statt, so dass das Einführen und Kontaktieren des Flachleiterbandes 28 in zwei nacheinander folgenden Schritten stattfindet.

Zum Schließen der Kontaktklemme wird nun der Gehäusedeckel 2 gegen das Solarmodul 24 kraftbeaufschlagt, wobei sich das Bodenelement 50 an dem Solarmodul 24 abstützt. Hierdurch kommt es zu einer linearen Relativverschiebung zwischen dem Gehäusedeckel 2 und dem Bodenelement 50 mit der Anschlussvorrichtung 20 dahingehend, dass der Gehäusedeckel 2 über das Bodenelement 50 und die Anschlussvorrichtung 20 geschoben wird, bis der Befestigungsrahmen 8 mit der Klebstoffnut 10 an der Oberfläche 24a des Solarmoduls 24 zur Anlage kommt und die Unterseite des Bodenelements 50 und des Gehäusedeckels 2 bündig an dem Solarmodul 24 anliegen. Dieser Zustand ist in Fig. 4 dargestellt.

Bezug nehmend auf Fig. 4 wird der Gehäusedeckel 2 mittels des in der Klebstoffnut 10 befindlichen Klebstoffs auf dem Solarmodul festgeklebt. Das Bodenelement 50 kann, muss aber nicht an dem Solarmodul 24 festgeklebt werden. Bei der Relativverschiebung des Gehäusedeckels 2 gegen das Bodenelement 50 und die Anschlussvorrichtung 20 wechselwirken ferner das Betätigungselement 18, in diesem Beispiel ein Betätigungssteg, mit der Klemmfeder 32. Durch diese Betätigung wird die Kontaktklemme 22 mittels einer Schwenkbewegung der Klemmfeder 32 geschlossen. Dabei überstreicht der Klemmabschnitt 34 der Klemmfeder 32 den Einfangraumbereich 31 und fängt das obere Ende des Flachleiterbandes 28 ein, um dieses zwischen dem Klemmabschnitt 34 der Klemmfeder 32 und dem Gegenklemmelement 36 elektrisch kontaktierend zu klemmen. Hierbei wird das Flachleiterband 28 abgewinkelt, da das Gegenklemmelement 36 in diesem Beispiel etwa unter 45° zur Solarmodulnormalen geneigt ist.

Die Klemmfeder 32 weist einen Betätigungsabschnitt 38 auf, der sich in einen gekrümmten Abschnitt 40 und einen im Wesentlichen geraden Abschnitt 42 unterteilt. Beim Schließen wirkt das Betätigungselement 18 zunächst auf den gekrümmten Abschnitt 40 (vgl. Fig. 3) und spannt in dem in Fig. 4 dargestellten, geschlossenen Kontaktzustand der Anschluss- und Verbindungsdose 1 gegen den geraden Abschnitt 42. D.h. das Betätigungselement 18 überstreicht beim Schließen den Betätigungsabschnitt 38 der Klemmfeder 32.

Die Anschlussvorrichtung 20 weist ferner eine Kabelanschlussklemme 46 für das nicht dargestellte elektrische Anschlusskabel auf.

In diesem Beispiel ist die Kabelanschlussklemme 46 ebenfalls mit einer Klemmfeder 48 versehen, hier können jedoch auch andere Anschlussvarianten, wie z. B. Schraubklemmen, zum Einsatz kommen.

In dem hier gezeigten Ausführungsbeispiel umfasst die Anschluss- und Verbindungsdose 1 zwei identisch ausgebildetet Anschlussvorrichtungen 20 zum gleichzeitigen Kontaktieren von zwei Flachleiterbändern 28. Es ist jedoch ersichtlich, dass die Erfindung hierauf nicht beschränkt ist und die Anschluss- und Verbindungsdose 1 auch nur eine oder mehr als zwei Anschlussvorrichtungen 20 umfassen kann.

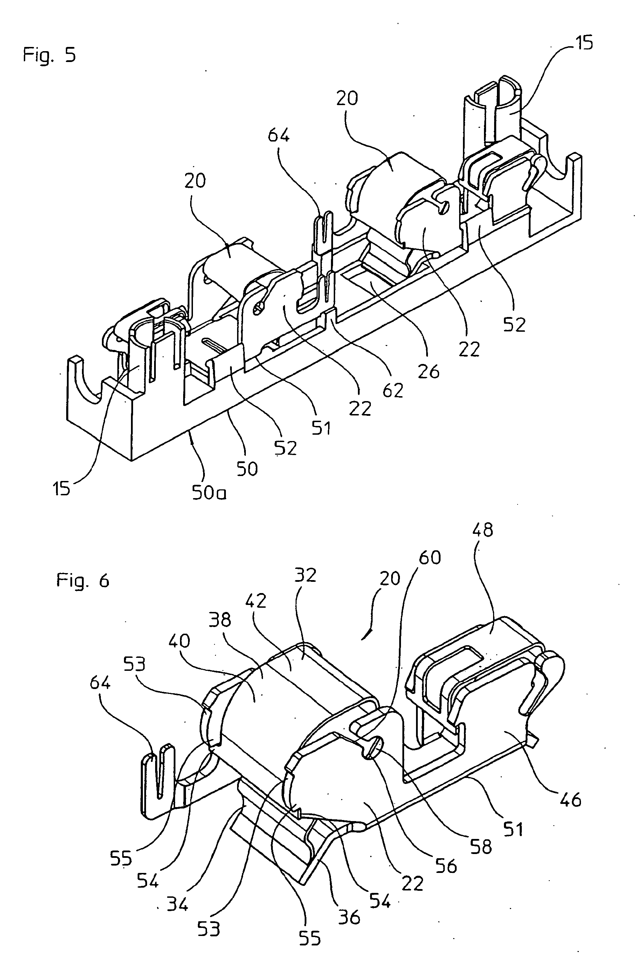

Bezug nehmend auf Fig. 5 ist die Anschlussvorrichtung 20 an dem Bodenelement 50 befestigt, welches in diesem Beispiel in Form eines dielektrischen, vorzugsweise aus Kunststoff hergestellten Trägers ausgebildet ist. Die Unterseite 50a des Bodenelements 50 definiert die primäre Anlagefläche zu dem Solarmodul 24 und die Einführöffnung 26. Die Anschlussvorrichtung 20 besitzt ferner einen im Wesentlichen U-förmigen, metallischen Halterahmen 51, vorzugsweise aus Kupfer, der mit Rasthaken 52 an dem Bodenelement 50 verrastet ist.

Die Fig. 5 und 6 zeigen die Kontaktklemme 22 in dem geschlossenen Kontaktzustand, in dem die Kontaktklemme 22 verrastet ist. Hierzu besitzt die Klemmfeder 32 zwei Rastzapfen 54, welche hinter korrespondierenden Vorsprüngen 55 in dem metallischen Halterahmen 51 eingerastet sind. In dem verrasteten Zustand ist die Kontaktfeder 32 gegen die Gegenklemme 36 vorgespannt. Dies sorgt für einen dauerhaften und sicheren elektrischen Kontakt. Das Flachleiterband 28 ist in den Fig. 5 und 6 nicht dargestellt.

Ferner ist die Klemmfeder 32 mittels Lagerzapfen 56 in geschlitzten Lageröffnungen 58 aufgehängt. Somit kann die Klemmfeder 32 bei der Herstellung der Anschluss- und Verbindungsdose leicht eingesetzt werden und ist aufgrund der im Montagezustand und Kontaktzustand relativ zu dem Schlitz 60 gedrehten Position des flachen Lagerzapfens 56 gesichert. Die Klemmfeder 32 ist aus Stahlblech gestanzt und im wesentlichen U-förmig gebogen.

Der metallische Halterahmen 51 weist ferner ein mittels einem Sockel 62 an dem Bodenelement 50 abgestütztes elektrisches Anschlusselement 64 für die Bypass-Diode auf.

Aufgrund der Form der beiden Abschnitte 40, 42 des Betätigungsabschnitts 38 der Klemmfeder 32 wird in dem geöffneten Montagezustand die Klemmfeder 32 so fixiert, dass der Einfangraumbereich 31 im Montagezustand offen gehalten wird. Durch das Aufsetzen der Anschluss- und Verbindungsdose 1 auf das Solarmodul gelangt bei dem in Fig. 1-6 dargestellten Ausführungsbeispiel das aus dem Solarmodul herausstehende Leiterband 28 von unten her unmittelbar in diesen Einfangraumbereich 31.

Durch das Zusammenwirken zwischen dem Gehäusedeckel 2 und dem Bodenelement 50 mit der Anschlussvorrichtung 20 vermittels des Betätigungselements 18 wird die Klemmfeder 32 gezwungen, die geöffnete Stellung zu verlassen, und wird in eine Schwenkbewegung versetzt.

Das Flachleiterband 28, welches sich in dem Einfangraumbereich 31 befindet, wird von dem Klemmabschnitt 34 erfasst und durch die fortdauernde Schwenkbewegung in einem Winkel von, in diesem Beispiel 45°, gegen das Gegenklemmelement 36 gedrückt. Zum Ende der Schwenkbewegung rastet die Klemmfeder mit ihren Rastnasen 54 in dem Kontakt- oder Betriebszustand (Fig. 4) in dem metallischen Halterahmen 51 ein. Durch die Vorspannung der Klemmfeder 32 wird eine dauerhafte und vordefinierte Andruckkraft zwischen dem Flachleiterband 28 und dem leitenden Gegenklemmelement 36 hergestellt.

Wieder Bezug nehmend auf Fig. 2 sind bei diesem Beispiel vier Führungsstifte 14 vorgesehen, um die Anschlussvorrichtung 20 mit dem Bodenelement 50 an lateral unterschiedlichen Postionen in dem Gehäusedeckel 2 anordnen zu können.

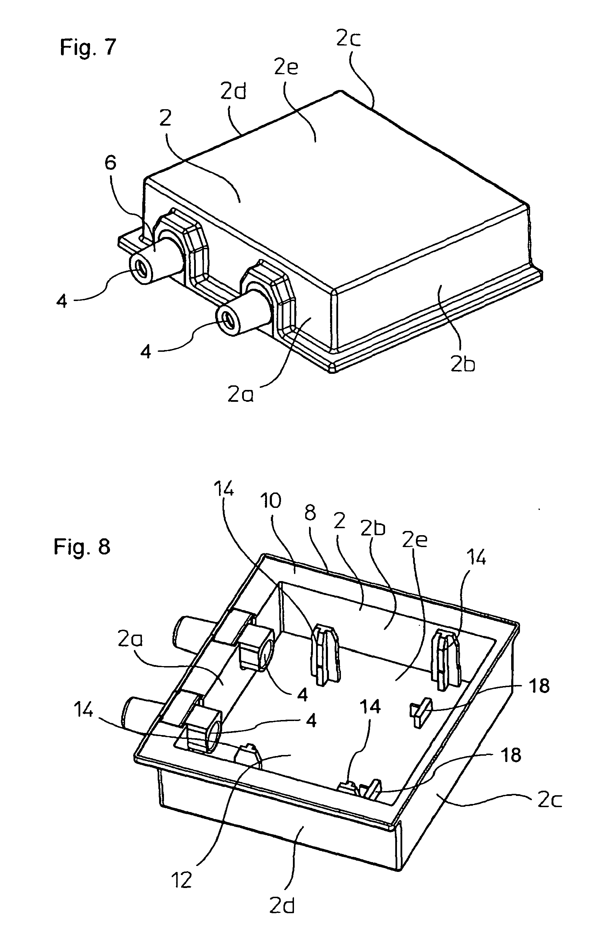

Die Fig. 7 und 8 zeigen eine Anschluss- und Verbindungsdose 1 gemäß einer zweiten Ausführungsform der Erfindung, bei der der Gehäusedeckel 2 eher quadratisch ausgebildet, um zwei Anschlussvorrichtungen 20 nebeneinander statt hintereinander wie bei der ersten Ausführungsform (Fig. 1-6) anzuordnen. Da die Kontaktklemme 22 und die Verschiebeeinrichtung 14, 15 bei dem ersten und zweiten Ausführungsbeispiel weitestgehend gleich ausgebildet sind, wird auf die vorstehende Beschreibung zum ersten Ausführungsbeispiel verwiesen, um Wiederholungen zu vermeiden.

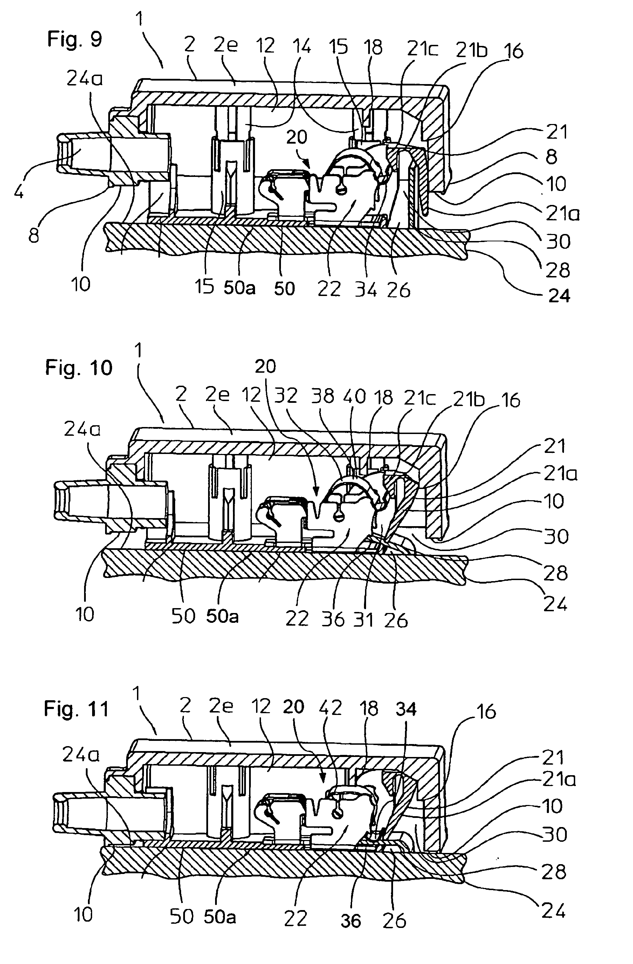

Die Unterseite der Deckelplatte 2e weist eine erste Betätigungseinrichtung 16 in Form einer seitlichen Nocke zur Betätigung des Umlenkhebels auf (in Fig. 8 nicht dargestellt, vgl. hierzu Fig. 9-11). Ferner ragen Betätigungsstifte 18 zur Betätigung der Kontaktklemmen von der Deckelplatte 2e in den Innenraum 12 des Gehäusedeckels 2. Die Nocke 16 und die Betätigungseinrichtung 18 sind in diesem Ausführungsbeispiel einstückig mit dem Gehäusedeckel 2 ausgebildet.

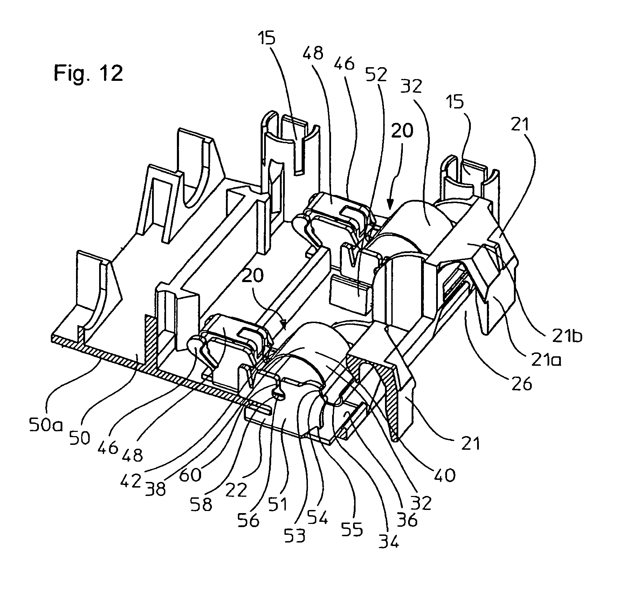

Bezug nehmend auf die Fig. 9-11 ist in dem Gehäuse 3 der Anschluss- und Verbindungsdose 1 die Anschlussvorrichtung 20 angeordnet. Bezug nehmend auf Fig. 12 besitzt diese Anschluss- und Verbindungsdose ebenfalls zwei identische Anschlussvorrichtungen 20, wobei im Folgenden lediglich auf eine der beiden Bezug genommen wird.

Fig. 9 zeigt die Anschluss- und Verbindungsdose nachdem diese über das Flachleiterband 28 gestülpt wurde. Die Anschluss- und Verbindungsdose befindet sich beim Überstülpen in einem ersten Zustand, dem Montagezustand, in dem sich der Umlenkhebel 21 in einer ersten Stellung befindet. In dem Montagezustand, in dem die Anschluss- und Verbindungsdose vorzugsweise ausgeliefert wird, ist der Zwischenraumbereich 30 über der Einführöffnung 26 freigehalten und die Kontaktklemme 22 geöffnet.

Die Anschluss- und Verbindungsdose 1 weist eine relativ große Einführöffnung 26 an ihrer dem Solarmodul 24 zugewandten Unterseite auf. Dies sorgt dafür, dass das empfindliche, flexible Flachleiterband 28, das sogenannte "Ribbon", in dem Montagezustand hindernis- und widerstandsfrei von unten in die Anschluss- und Verbindungsdose 1 eingeführt wird. Hierdurch ist die Gefahr einer Beschädigung des Flachleiterbandes 28 reduziert. Die Anschluss- und Verbindungsdose 1 definiert in diesem Zustand einen zwischen der Kontaktklemme 22 und dem Umlenkhebel 21 befindlichen offenen Zwischen- oder Einführraumbereich 30, in den das Flachleiterband 28 beim Aufsetzen der Anschluss- und Verbindungsdose von unten her widerstandsfrei eintaucht. Vorzugsweise findet in diesem Zustand noch keine Berührung zwischen der Kontaktklemme 22 oder dem Umlenkhebel 21 und dem Flachleiterband 28 statt.

Zum Kontaktieren des Flachleiterbandes 28 wird nun der Gehäusedeckel 2 gegen das Solarmodul 24 kraftbeaufschlagt, wobei die Anschlussvorrichtung 20 sich an dem Solarmodul 24 abstützt. Hierdurch kommt es zu einer linearen Relativverschiebung zwischen dem Gehäusedeckel 2 und dem Bodenelement 50 mit der Anschlussvorrichtung 20 dahingehend, dass der Gehäusedeckel 2 über die Anschlussvorrichtung 20 geschoben wird, bis der Befestigungsrahmen 8 mit dem in der Klebstoffnut 10 befindlichen Klebstoff (nicht dargestellt) an der Oberfläche des Solarmoduls 24 zur Anlage kommt und die Unterseite 50a des Bodenelements 50 und des Gehäusedeckels 2 bündig an dem Solarmodul 24 anliegen. Dieser geschlossene Kontaktzustand stellt den End- oder Betriebszustand dar und ist in Fig. 11 dargestellt. In dem Betriebszustand ist das Gehäuse 3 mittels des in der Klebstoffnut 10 befindlichen Klebstoffs auf dem Solarmodul 24 festgeklebt.

Bevor die Anschluss- und Verbindungsdose 1 jedoch in den Endzustand gelangt, durchläuft sie noch den in Fig. 10 dargestellten Zwischenzustand, in welchem das Flachleiterband 28 bereits umgebogen ist und die Kontaktklemme 22 noch geöffnet ist. Es wird also beim Aufsetzen der Anschluss- und Verbindungsdose 1 zunächst das Flachleiterband 28 in den Einführraumbereich 30 eingeführt, nachfolgend wird, nachdem die Unterseite 50a des Bodenelements 50 auf dem Solarmodul 24 zur Anlage gekommen ist, das Flachleiterband 28 mittels des Umlenkhebels 21 in den Einfangraumbereich 31 der Kontaktklemme 22 umgebogen. Weiter nachfolgend wird die Kontaktklemme 22 aktiv mittels des zweiten Betätigungselements 18 geschlossen. Somit definiert die Anschluss- und Verbindungsdose 1 drei vordefinierte Zustände, nämlich den Montagezustand (Fig. 9), in dem sich der Umlenkhebel 21 in einer ersten Position befindet, so dass der Einführraumbereich 30 frei ist und die Kontaktklemme 22 geöffnet ist; den Zwischenzustand (Fig. 10), in dem das Flachleiterband 28 von dem Umlenkhebel 21 in den Einfangraumbereich 31 der noch immer geöffneten Kontaktaktklemme 22 umgebogen ist; und den End- oder Betriebszustand (Fig. 11), in dem die Kontaktklemme 22 geschlossen ist, und den elektrischen Kontakt mit dem Flachleiterband 28 mittels Klemmkontaktierung herstellt. Bei dieser Ausführungsform erfolgt die Kontaktierung des Flachleiterbandes 28 parallel zur Oberfläche des Solarmoduls 24.

Bei der Relativverschiebung des Gehäusedeckels 2 gegen das Bodenelement 50 und die Anschlussvorrichtung 20 wechselwirken demnach zunächst das erste Betätigungselement 16, in diesem Beispiel eine Betätigungsnocke, mit dem Umlenkhebel 21 und nachfolgend das zweite Betätigungselement 18, in diesem Beispiel ein Betätigungsstift, mit der Klemmfeder 32. Durch diese sukzessive Betätigung wird zunächst der Biegeabschnitt 21a des Umlenkhebels 21 in Ansprechen auf eine Betätigung mittels der Nocke 16 ausgelenkt und nachfolgend die Kontaktklemme 22 mittels einer Schwenkbewegung der Klemmfeder 32 geschlossen. Die Nocke 16 ist in diesem Beispiel als Vorsprung der Seitenwand des Gehäusedeckels 2 einstückig mit diesem ausgebildet. Nachfolgend überstreicht der Klemmabschnitt 34 der Klemmfeder 32 den Einfangraumbereich 31 der Kontaktklemme und klemmt und kontaktiert freie Ende des Flachleiterbandes 28 zwischen dem Klemmabschnitt 34 der Klemmfeder 32 und dem Gegenklemmelement 36. Der Biegeabschnitt 21a des Umlenkhebels 21 ist einstückig mittels einem Falzscharnier 21b mit einem Halteabschnitt 21c verbunden. Der Halteabschnitt 21c ist an dem Bodenelement 50 befestigt, genauer einstückig mit diesem ausgebildet.

Bezug nehmend auf Fig. 12 umfasst die Anschluss- und Verbindungsdose 1 in diesem Beispiel zwei Anschlussvorrichtungen 20. Die Anschlussvorrichtungen 20 sind oberseitig an dem dielektrischen Bodenelement 50 befestigt. Fig. 12 zeigt die Kontaktklemme 22 in dem geöffneten Montagezustand. Die Klemmfeder 32 weist zwei Rastzapfen 54 auf, welche in dem geöffneten Montagezustand jeweils in Vertiefungen 53 in dem metallischen Halterahmen 51 überwindbar festgeklemmt sind.

Wieder Bezug nehmend auf Fig. 9-11 werden durch das Zusammenwirken zwischen dem Gehäusedeckel 2 und dem Kunststoff-Bodenelement 50 mit der daran befestigten Anschlussvorrichtung 20 vermittels der Betätigungselemente 16 und 18 nacheinander der Biegeabschnitt 21a des Umlenkhebels 21 und die Klemmfeder 32 in eine Schwenkbewegung versetzt. Zum Ende der Schwenkbewegung rastet die Klemmfeder mit ihren Rastnasen 54 in dem Kontaktzustand (Fig. 11) hinter Vorsprüngen 55 in dem metallischen Halterahmen 51 ein. Durch die Vorspannung der Klemmfeder 32 wird eine dauerhafte und vordefinierte Andruckkraft zwischen dem Flachleiterband 28 und dem leitenden Gegenklemmelement 36 hergestellt.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne den durch die Patentansprüche bestimmten Schutzbereich zu verlassen. Insbesondere kann die Anschluss- und Verbindungsdose eine oder eine Mehrzahl von Kontaktklemmen aufweisen, um eine oder eine Mehrzahl von Flachleiterbändern in der Anschluss- und Verbindungsdose zu kontaktieren. Ferner ist ersichtlich, dass die Merkmale unabhängig davon, ob sie in der Beschreibung, den Ansprüchen, den Figuren oder anderweitig offenbart sind auch einzeln wesentliche Bestandteile der Erfindung definieren, selbst wenn sie zusammen mit anderen Merkmalen gemeinsam beschrieben sind.

## Patentansprüche

1. Anschluss- und Verbindungsdose (1) für ein photovoltaisches Solarmodul (24) mit zumindest einem flexiblen Flachleiterband (28), das aus der Oberfläche des Solarmoduls herausragt, umfassend
ein dielektrisches Gehäuse (3) zum Aufsetzen auf das Solarmodul (24) und mit einer Einführöffnung (26) an der im montierten Zustand dem Solarmodul (24) zugewandten Seite (50a) des Gehäuses (3) zum Einführen des Flachleiterbands (28) in das Gehäuse (3),
eine von dem Gehäuse (3) beherbergte Anschlussvorrichtung (20) mit einer Kontaktklemme (22) zum elektrischen Kontaktieren des flexiblen Flachleiterbands (28),
wobei die Anschluss- und Verbindungsdose (1) einen Montagezustand und einen Kontaktzustand definiert,
**dadurch gekennzeichnet, dass**
die Kontaktklemme (22) in dem Montagezustand geöffnet ist, um das flexible Flachleiterband (28) in die geöffnete Kontaktklemme (22) einführen zu können,
die Kontaktklemme (22) in dem Kontaktzustand geschlossen ist, um das flexible Flachleiterband (28) elektrisch zu kontaktieren,
das Gehäuse (3) zumindest zweiteilig ausgebildet ist und die beiden Gehäuseteile (2, 50) relativ zueinander bewegbar sind und
die Anschluss- und Verbindungsdose (1) eine Betätigungseinrichtung (18) zum Schließen der Kontaktklemme (22) aufweist, wobei die Betätigungseinrichtung (18) in Ansprechen auf eine Relativbewegung zwischen den beiden Gehäuseteilen (2, 50) automatisch die.Kontaktklemme (22) schließt, um das flexible Flachleiterband (28) zu kontaktieren, wenn die Anschluss- und Verbindungsdose (1) auf das Solarmodul (24) aufgesetzt und das flexible Flachleiterband (28) in das Gehäuse (3) eingeführt ist.

2. Anschluss- und Verbindungsdose (1) nach Anspruch 1, wobei das Gehäuse (3) eine Verschiebeeinrichtung (14, 15) aufweist, mittels welcher die beiden Gehäuseteile (2, 50) quer zu der Oberfläche (24a) des Solarmoduls (24) relativ zueinander verschiebbar sind und die Betätigungseinrichtung (18) in Ansprechen auf eine Relativverschiebung zwischen den beiden Gehäuseteilen (2, 50) automatisch die Kontaktklemme (22) schließt, um das flexible Flachleiterband (28) zu kontaktieren.

3. Anschluss- und Verbindungsdose (1) nach Anspruch 2, wobei die Verschiebeeinrichtung (14, 15) eine Mehrzahl von in Führungshülsen (15) geführten Führungsstiften (14) aufweist, welche an den beiden Gehäuseteilen (2, 50) vorgesehen sind.

4. Anschluss- und Verbindungsdose (1) nach Anspruch 2 oder 3, wobei die Verschiebeeinrichtung (14, 15) in dem Montagezustand selbsthemmend ausgebildet ist, derart dass beim Fassen und Handhaben lediglich eines der beiden Gehäuseteile (2) das andere Gehäuseteil (50) nicht herausfällt.

5. Anschluss- und Verbindungsdose (1) nach Anspruch 2, 3 oder 4, wobei in dem Montagezustand das erste (50) der beiden Gehäuseteile an der dem Solarmodul zugewandten Seite über das zweite (2) der beiden Gehäuseteile hinausragt, derart dass beim Aufsetzen der Anschluss- und Verbindungsdose (1) auf das Solarmodul (24) zunächst nur das erste Gehäuseteil (50) an dem Solarmodul (24) zur Anlage kommt, und wobei durch Kraftbeaufschlagung auf das zweite Gehäuseteil (2) in Richtung des Solarmoduls (24) die Relativverschiebung des zweiten Gehäuseteils (2) gegenüber dem ersten Gehäuseteil (50) bewirkt wird, um mittels der Betätigungseinrichtung (18) die Kontaktklemme (22) zu schließen.

6. Anschluss- und Verbindungsdose (1) nach einem der vorstehenden Ansprüche, wobei das Gehäuse (3) zumindest zweiteilig ausgebildet ist und das erste (50) der beiden Gehäuseteile als Bodenelement zur Anlage an das Solarmodul und das zweite (2) der beiden Gehäuseteile als Deckelteil ausgebildet ist und zumindest eines der beiden Gehäuseteile (2, 50) umlaufende Seitenwände (2a-d) aufweist, so dass das erste und zweite Gehäuseteil (2, 50) gemeinsam, abgesehen von vordefinierten Öffnungen, eine geschlossene und zumindest spritzwasserdichte Box für die Anschlussvorrichtung (1) definiert, wenn das Gehäuse (3) in dem Kontaktzustand mit dem Solarmodul (24) fest verbunden ist.

7. Anschluss- und Verbindungsdose (1) nach Anspruch 6, wobei das Deckelteil (2) einen umlaufenden Rand (8) mit einer Klebstoffnut (10) aufweist, um das Deckelteil (2) auf der Oberfläche (24a) des Solarmoduls (24) festzukleben.

8. Anschluss- und Verbindungsdose (1) nach einem der vorstehenden Ansprüche, wobei die Kontaktklemme (22) als eine Federkraftklemme mit einer Klemmfeder (32) und einem Gegenklemmelement (36) ausgebildet ist, wobei die Federkraftklemme im Montagezustand von sich aus geöffnet ist und durch Kraftbeaufschlagung mittels der
Betätigungseinrichtung (18) schließbar ist.

9. Anschluss- und Verbindungsdose (1) nach Anspruch 8, wobei die Klemmfeder (32) und/oder das Gegenklemmelement (36) schwenkbar an der Anschlussvorrichtung (20) gelagert ist und der elektrische Kontakt mit dem flexiblen Flachleiterband (28) mittels einer Schwenkbewegung zumindest eines der Klemmfeder (32) oder des Gegenklemmelementes (36) in Ansprechen auf die Betätigung mittels der Betätigungseinrichtung (18) geschlossen wird.

10. Anschluss- und Verbindungsdose (1) nach einem der vorstehenden Ansprüche, wobei die Kontaktklemme (22) einen Rastmechanismus (54, 55) aufweist, mittels welchem die Klemmfeder (32) in dem Kontaktzustand verrastet ist.

11. Anschluss- und Verbindungsdose (1) nach einem der vorstehenden Ansprüche, wobei beim Aufsetzen der Anschluss- und Verbindungsdose das flexible Flachleiterband (28) durch die Einführöffnung (26) hindurch im Wesentlichen widerstandsfrei entweder
direkt in den offenen Einfangraumbereich (1) der geöffneten Kontaktklemme (22) eingeführt wird oder
in einen offenen Zwischenraumbereich (30) in dem Gehäuse (3) eingeführt wird und die Anschluss- und Verbindungsdose (1) eine Umlenkeinrichtung (21) für das flexible Flachleiterband (28) aufweist, welche das flexible Flachleiterband (28) von dem Zwischenraumbereich (30) in den Einfangraumbereich (31) der Kontaktklemme umlenkt.

12. Photovoltaisches Solarmodul (24) mit zumindest einem aus der Oberfläche (24a) herausragenden flexiblen Flachleiterband (28), und zumindest einer auf das Solarmodul (24) montierten Anschluss- und Verbindungsdose (1) gemäß einem der vorstehenden Ansprüche.

13. Verfahren zum Anschließen einer Anschluss- und Verbindungsdose (1) an ein photovoltaisches Solarmodul, umfassend die Schritte:
Bereitstellen eines Solarmoduls (24) mit zumindest einem flexiblen Flachleiterband (28), das aus der Oberfläche (24a) des Solarmoduls (24) herausragt,
Bereitstellen einer Anschluss- und Verbindungsdose (1), welche ein Gehäuse (3) sowie eine in dem Gehäuse (3) angeordnete Anschlussvorrichtung (20) mit einer elektrischen Kontaktklemme (22) zum Herstellen eines Klemmkontaktes mit dem flexiblen Flachleiterband (28) umfasst, und eine Einführöffnung (26) an der Unterseite der Anschluss- und Verbindungsdose (1) sowie eine Betätigungseinrichtung (18) zum Betätigen der Kontaktklemme (22) aufweist,
Aufsetzen der Anschluss- und Verbindungsdose (1) auf das Solarmodul (24), wobei die Anschluss- und Verbindungsdose (1) mit der Einführöffnung (26) über das flexible Flachleiterband (28) gestülpt wird,
Einführen des flexiblen Flachleiterbandes (28) in den Einfangraumbereich (31) der geöffneten Kontaktklemme (22) entweder unmittelbar beim oder nach dem Überstülpen der Anschluss- und Verbindungsdose (1) über das flexible Flachleiterband (28),
Bewirken einer Relativbewegung zwischen zwei Gehäuseteilen (2, 50), wodurch die Kontaktklemme (22) mittels der Betätigungseinrichtung (18) geschlossen wird und hierbei das flexible Flachleiterband (28) kontaktiert wird.

14. Verfahren nach Anspruch 13, wobei das Gehäuse (3) ein Bodenelement (50) und ein Deckelteil (2) umfasst, wobei die Anschlussvorrichtung (20) an dem Bodenelement (50) befestigt ist und zusammen mit dem Bodenelement (50) relativ zu dem Deckelteil (2) verschiebbar ist, wobei die Verschiebeeinrichtung (14, 15) überwindbar selbsthemmend ausgelegt ist, so dass das Bodenelement (50) und die Anschlussvorrichtung (20) beim Aufsetzen der Anschluss- und Verbindungsdose (1) auf das Solarmodul (24) nicht von dem Deckelteil (2) abfallen, wobei das Bodenelement (50) in dem Montagezustand nach unten aus dem Deckelteil (2) herausragt, so dass beim Aufsetzen auf das Solarmodul (24) zunächst nur das Bodenelement (50) mit der Oberfläche (24a) des Solarmoduls (24) zur Anlage gebracht wird,
wobei das Deckelteil (2) in Richtung des Solarmoduls (24) kraftbeaufschlagt wird, derart, dass das Deckelteil (2) relativ zu dem Bodenelement (50) und der Anschlussvorrichtung (20) verschoben wird, bis das Deckelteil (2) ebenfalls an dem Solarmodul (24) zur Anlage kommt, wobei die Kontaktklemme (22) in Ansprechen auf die Relativverschiebung zwischen dem Deckelteil (2) und dem Bodenelement (50) automatisch geschlossen wird.

## Claims

1. Connection and junction box (1) for a photovoltaic solar module (24) having at least one flexible flat conductor band (28) protruding from the surface of the solar module, comprising
a dielectric housing (3) to be placed onto the solar module (24), having an insertion mouth (26) at the side (50a) of the housing (3) facing the solar module (24) in the mounted state, for inserting the flat conductor band (28) into the housing (3),
a connection device (20) housed in the housing (3), having a contact clamp (22) for electrically contacting the flexible flat conductor band (28),
wherein the connection and junction box (1) defines a mounting state and a contacting state,
**characterised in that**
the contact clamp (22) is open in the mounting state in order to be able to insert the flexible flat conductor band (28) into the open contact clamp (22),
the contact clamp (22) is closed in the contacting state for electrically contacting the flexible flat conductor band (28),
the housing (3) is formed in at least two parts, and the two housing parts (2, 50) are movable with respect to each other, and
the connection and junction box (1) has an actuation arrangement (18) for closing the contact clamp (22), wherein the actuation arrangement (18) automatically closes the contact clamp (22) in response to a relative movement between the two housing parts (2, 50) for contacting the flexible flat conductor band (28), when the connection and junction box (1) is placed onto the solar module (24) and the flexible flat conductor band (28) is inserted into the housing (3).

2. Connection and junction box (1) as claimed in Claim 1, wherein the housing (3) has a sliding arrangement (14, 15), by means of which the two housing parts (2, 50) are slideable with respect to each other transversely to the surface (24a) of the solar module (24), and the actuation arrangement (18) automatically closes the contact clamp (22) in response to relative sliding movement between the two housing parts (2, 50), for contacting the flexible flat conductor band (28).

3. Connection and junction box (1) as claimed in Claim 2, wherein the sliding arrangement (14, 15) has a plurality of guide pins (14) guided in guide sleeves (15) and provided on the two housing parts (2, 50).

4. Connection and junction box (1) as claimed in Claim 2 or 3, wherein the sliding arrangement (14, 15) is formed to be self-locking in the mounting state such that when grasping and handling only one of the two housing parts (2) the other housing part (50) does not fall off.

5. Connection and junction box (1) as claimed in Claim 2, 3 or 4, wherein in the mounting state, the first (50) of the two housing parts protrudes beyond the second (2) of the two housing parts on the side facing the solar module such that when placing the connection and junction box (1) onto the solar module (24), firstly only the first housing part (50) bears against the solar module (24), and wherein the relative sliding movement of the second housing part (2) with respect to the first housing part (50) is effected by applying a force to the second housing part (2) in the direction of the solar module (24), for closing the contact clamp (22) by means of the actuation arrangement (18).

6. Connection and junction box (1) as claimed in any one of the preceding claims, wherein the housing (3) is formed in at least two parts, and the first (50) of the two housing parts is formed as a base element for bearing against the solar module (24), and the second (2) of the two housing parts is formed as a cover part, and at least one of the two housing parts (2, 50) comprises circumferential side walls (2a-d) so that the first and the second housing parts (2, 50) together define, except for predefined openings, a closed and at least splash-water-impermeable box for the connection device (1), when the housing (3) is fixedly connected to the solar module (24) in the contacting state.

7. Connection and junction box (1) as claimed in Claim 6, wherein the cover part (2) comprises a circumferential rim (8) with a glue notch (10) for gluing the cover part (2) on the surface (24a) of the solar module (24).

8. Connection and junction box (1) as claimed in any one of the preceding claims, wherein the contact clamp (22) is formed as a spring force clamp with a clamp spring (32) and a counter clamp element (36), wherein the spring force clamp is open of its own accord in the mounting state and can be closed by applying a force by means of the actuation arrangement (18).

9. Connection and junction box (1) as claimed in Claim 8, wherein the clamp spring (32) and/or the counter clamp element (36) is pivotably mounted on the connection device (20) and the electrical contact with the flexible flat conductor band (28) is closed by means of a pivoting movement at least of one of the clamp spring (32) or the counter clamp element (36) in response to the actuation by means of the actuation arrangement (18).

10. Connection and junction box (1) as claimed in any one of the preceding claims, wherein the contact clamp (22) comprises a latching mechanism (54, 55), by means of which the clamp spring (32) is latched in the contacting state.

11. Connection and junction box (1) as claimed in any one of the preceding claims, wherein, when placing the connection and junction box, the flexible flat conductor band (28) is inserted through the insertion mouth (26) in a substantially resistance-free manner either
directly into the open capture area (1) of the open contact clamp (22), or
into an open intermediate area (30) in the housing (3), and the connection and junction box (1) comprises a deflection arrangement (21) for the flexible flat conductor band (28), which arrangement deflects the flexible flat conductor band (28) from the intermediate area (30) into the capture area (31) of the contact clamp.

12. Photovoltaic solar module (24) having at least one flexible flat conductor band (28) protruding from the surface (24a), and at least one connection and junction box (1) as claimed in any one of the preceding claims, mounted on the solar module (24).

13. Method for connecting a connection and junction box (1) to a photovoltaic solar module, comprising the steps of:
providing a solar module (24) having at least one flexible flat conductor band (28) protruding from the surface (24a) of the solar module (24),
providing a connection and junction box (1) comprising a housing (3) and a connection device (20) which is disposed in the housing (3) and has an electrical contact clamp (22) for establishing a clamp contact with the flexible flat conductor band (28), and an insertion mouth (26) at the lower side of the connection and junction box (1) as well as an actuation arrangement (18) for actuating the contact clamp (22),
placing the connection and junction box (1) onto the solar module (24), wherein the connection and junction box (1) is placed with the insertion mouth (26) over the flexible flat conductor band (28),
inserting the flexible flat conductor band (28) into the capture area (31) of the open contact clamp (22), either directly during or after placing the connection and junction box (1) over the flexible flat conductor band (28),
effecting a relative movement between two housing parts (2, 50), whereby the contact clamp (22) is closed by means of the actuation arrangement (18), and the flexible flat conductor band (28) is contacted in this case.

14. Method as claimed in Claim 13, wherein the housing (3) comprises a base element (50) and a cover part (2), wherein the connection device (20) is attached to the base element (50), and is slideable together with the base element (50) with respect to the cover part (2), wherein the sliding arrangement (14, 15) is designed to be self-locking, in such a manner that this self-locking can be overcome, so that the base element (50) and the connection device (20) do not fall off from the cover part (2) when placing the connection and junction box (1) onto the solar module (24), wherein the base element (50) protrudes downwardly from the cover part (2) in the mounting state so that, during placement on the solar module (24), at first only the base element (50) is moved against the surface (24a) of the solar module (24),
wherein a force is applied to the cover part (2) in the direction of the solar module (24) such that the cover part (2) is shifted with respect to the base element (50) and to the connection device (20) until the cover part (2) also bears against the solar module (24), wherein the contact clamp (22) is automatically closed in response to the relative sliding movement between the cover part (2) and the base element (50).

## Revendications

1. Boîtier de raccordement et de connexion (1) pour un module solaire photovoltaïque (24) avec au moins une bande de conducteur plat (28), qui dépasse de la surface du module solaire, comprenant :
un boîtier diélectrique (3) à placer sur le module solaire (24) et avec une ouverture d'introduction (26) sur le côté (50a) du boîtier (3) opposé au module solaire (24) à l'état monté pour l'introduction de la bande de conducteur plat (28) dans le boîtier (3),
un dispositif de raccordement (20) hébergé par le boîtier (3) avec une borne de contact (22) pour établir un contact électrique avec la bande de conducteur plat (28) souple,
le boîtier de raccordement et de connexion (1) définissant un état de montage et un état de contact,
**caractérisé en ce que** :
la borne de contact (22) est ouverte à l'état de montage afin de pouvoir introduire la bande de conducteur plat (28) souple dans la borne de contact (22) ouverte,
la borne de contact (22) est fermée à l'état de contact afin d'établir un contact électrique avec la bande de conducteur plat (28) souple,
le boîtier (3) est réalisé au moins en deux parties et les deux parties de boîtier (2, 50) peuvent être déplacées relativement l'une par rapport à l'autre, et
le boîtier de raccordement et de connexion (1) présente un dispositif d'actionnement (18) afin de fermer la borne de contact (22), le dispositif d'actionnement (18) fermant automatiquement la borne de contact (22) en réponse à un mouvement relatif entre les deux parties de boîtier (2, 50) afin d'établir un contact avec la bande de conducteur plat (28) souple, lorsque le boîtier de raccordement et de connexion (1) est placé sur le module solaire (24) et la bande de conducteur plat (28) souple est introduite dans le boîtier (3).

2. Boîtier de raccordement et de connexion (1) selon la revendication 1, le boîtier (3) présentant un dispositif de déplacement (14, 15), au moyen duquel les deux parties de boîtier (2, 50) peuvent être déplacées relativement l'une par rapport à l'autre transversalement à la surface (24a) du module solaire (24) et le dispositif d'actionnement (18) ferme automatiquement la borne de contact (22) en réponse à un déplacement relatif entre les deux parties de boîtier (2, 50) afin d'établir un contact avec la bande de conducteur plat (28) souple.

3. Dispositif de raccordement et de connexion (1) selon la revendication 2, le dispositif de déplacement (14, 15) présentant une pluralité d'ergots de guidage (14) guidés dans des douilles de guidage (15), lesquels ergots sont prévus sur les deux parties de boîtier (2, 50).

4. Dispositif de raccordement et de connexion (1) selon la revendication 2 ou 3, le dispositif de déplacement (14, 15) étant configuré de manière autobloquante à l'état de montage, de telle sorte que lors de la saisie et de la manipulation d'une seule des deux parties de boîtier (2), l'autre partie de boîtier (50) ne tombe pas.

5. Dispositif de raccordement et de connexion (1) selon la revendication 2, 3 ou 4, la première (50) des deux parties de boîtier dépassant de la deuxième (2) des deux parties de boîtier à l'état de montage sur le côté opposé au module solaire, de telle sorte que, lors du placement du boîtier de raccordement et de connexion (1) sur le module solaire (24), tout d'abord seule la première partie de boîtier (50) vient prendre appui sur le module solaire (24), et par le biais de l'application d'une force sur la deuxième partie de boîtier (2) dans la direction du module solaire (24), le déplacement relatif de la deuxième partie de boîtier (2) par rapport à la première partie de boîtier (50) est provoqué afin de fermer la borne de contact (22) au moyen du dispositif d'actionnement (18).

6. Boîtier de raccordement et de connexion (1) selon l'une des revendications précédentes, le boîtier (3) étant réalisé au moins en deux parties, et la première (50) des deux parties de boîtier étant réalisée en tant qu'élément inférieur pour prendre appui sur le module solaire, et la deuxième (2) des deux parties de boîtier étant réalisée en tant que partie supérieure, et au moins une des deux parties de boîtier (2, 50) présentant des parois latérales circonférentielles (2a-d), de sorte que les première et deuxième parties de boîtier (2, 50) définissent en commun, à l'exception d'ouvertures prédéfinies, un boîtier fermé et au moins étanche aux projections d'eau pour le dispositif de raccordement (1), lorsque le boîtier (3) est connecté de manière fixe au module solaire (24) à l'état de contact.

7. Boîtier de raccordement et de connexion (1) selon la revendication 6, la partie supérieure (2) présentant un bord circonférentiel (8) avec une rainure adhésive (10) afin de coller la partie supérieure (2) sur la surface (24a) du module solaire (24).

8. Boîtier de raccordement et de connexion (1) selon l'une des revendications précédentes, la borne de contact (22) étant réalisée en tant que borne élastique avec un ressort de serrage (32) et un élément de contre-serrage (36), la borne élastique étant ouverte en elle-même à l'état de montage et pouvant être fermée par le biais de l'application d'une force au moyen du dispositif d'actionnement (18).

9. Boîtier de raccordement et de connexion (1) selon la revendication 8, le ressort de serrage (32) et/ou l'élément de contre-serrage (36) étant logés de manière pivotante sur le dispositif de raccordement (20), et le contact électrique avec la bande de conducteur plat (28) étant fermé au moyen d'un mouvement pivotant au moins du ressort (32) ou de l'élément de contre-serrage (36) en réponse à l'actionnement au moyen du dispositif d'actionnement (18).

10. Boîtier de raccordement et de connexion (1) selon l'une des revendications précédentes, la borne de contact (22) présentant un mécanisme d'encliquetage (54, 55), au moyen duquel le ressort de serrage (32) est encliqueté à l'état de contact.

11. Boîtier de raccordement et de connexion (1) selon l'une des revendications précédentes, lors du placement du boîtier de raccordement et de connexion, la bande de conducteur plat (28) souple étant introduite à travers l'ouverture d'introduction (26) pour l'essentiel sans résistance :
soit directement dans la zone de capture (1) ouverte de la borne de contact (22) ouverte,
soit dans une zone intermédiaire (30) ouverte dans le boîtier (3), et le boîtier de raccordement et de connexion (1) présentant un dispositif de déviation (21) pour la bande de conducteur plat (28) souple, qui dévie la bande de conducteur plat (28) souple de la zone intermédiaire (30) dans la zone de capture (31) de la borne de contact.

12. Module solaire photovoltaïque (24) avec au moins une bande de conducteur plat (28) souple dépassant de la surface (24a), et au moins un boîtier de raccordement et de connexion (1) monté sur le module solaire (24) selon l'une des revendications précédentes.

13. Procédé de raccordement d'un boîtier de raccordement et de connexion (1) à un module solaire photovoltaïque, comprenant les étapes de :
préparation d'un module solaire (24) avec au moins une bande de conducteur plat (28) souple, qui dépasse de la surface (24a) du module solaire (24),
préparation d'un boîtier de raccordement et de connexion (1), qui comprend un boîtier (3) ainsi qu'un dispositif de raccordement (20) disposé dans le boîtier (3) avec une borne de contact (22) électrique afin de produire un contact de serrage avec la bande de conducteur plat (28) souple, et présente une ouverture d'introduction (26) sur le côté inférieur du boîtier de raccordement et de connexion (1) ainsi qu'un dispositif d'actionnement (18) afin d'actionner la borne de contact (22),
placement du boîtier de raccordement et de connexion (1) sur le module solaire (24), le boîtier de raccordement et de connexion (1) étant disposé avec l'ouverture d'introduction (26) par-dessus la bande de conducteur plat (28) souple,
introduction de la bande de conducteur plat (28) souple dans la zone de capture (31) de la borne de contact (22) ouverte soit directement pendant ou soit après le placement du boîtier de raccordement et de connexion (1) par-dessus la bande de conducteur plat (28) souple,
réalisation d'un mouvement relatif entre deux parties de boîtier (2, 50), moyennant quoi la borne de contact (22) est fermée au moyen du dispositif d'actionnement (18) et à cette occasion un contact est établi avec la bande de conducteur plat (28) souple.

14. Procédé selon la revendication 13, le boîtier (3) comprenant un élément inférieur (50) et une partie supérieure (2), le dispositif de raccordement (20) étant fixé sur l'élément inférieur (50) et pouvant être déplacé conjointement avec l'élément inférieur (50) par rapport à la partie supérieure (2), le dispositif de déplacement (14, 15) étant prévu de manière surmontable et autobloquante, de sorte que l'élément inférieur (50) et le dispositif de raccordement (20) ne tombent pas de la partie supérieure (2) lors du placement du boîtier de raccordement et de connexion (1) sur le module solaire (24), l'élément inférieur (50) dépassant de la partie supérieure (2) vers le bas à l'état de montage, de sorte que lors du placement sur le module solaire (24) seul l'élément inférieur (50) est tout d'abord mis en appui avec la surface supérieure (24a) du module solaire (24),
une force étant appliquée sur la partie supérieure (2) dans la direction du module solaire (24), de telle sorte que la partie supérieure (2) est déplacée par rapport à l'élément inférieur (50) et au dispositif de raccordement (20), jusqu'à ce que la partie supérieure (2) prenne également appui sur le module solaire (24), la borne de contact (22) étant fermée automatiquement en réponse au déplacement relatif entre la partie supérieure (2) et l'élément inférieur (50).
